(19) Europäisches Patentamt / European Patent Office / Office européen des brevets

(11) **EP 1 606 215 B1**

(12) **EUROPEAN PATENT SPECIFICATION**

(45) Date of publication and mention
of the grant of the patent:
**17.12.2008 Bulletin 2008/51**

(51) Int Cl.:
**G11C 13/00** (2006.01)

(21) Application number: **04714416.7**

(86) International application number:
**PCT/IL2004/000191**

(22) Date of filing: **25.02.2004**

(87) International publication number:
**WO 2004/076344 (10.09.2004 Gazette 2004/37)**

(54) **NANOSCOPIC STRUCTURE AND DEVICES USING THE SAME**

NANOSKOPISCHE STRUKTUR UND DIESE VERWENDENDE VORRICHTUNG

STRUCTURE NANOSCOPIQUE ET DISPOSITIFS UTILISANT CETTE STRUCTURE

(84) Designated Contracting States:
**AT BE BG CH CY CZ DE DK EE ES FI FR GB GR HU IE IT LI LU MC NL PT RO SE SI SK TR**

(30) Priority: **25.02.2003 US 449433 P**

(43) Date of publication of application:
**21.12.2005 Bulletin 2005/51**

(73) Proprietor: **YEDA RESEARCH AND DEVELOPMENT CO., LTD.**
**76100 Rehovot (IL)**

(72) Inventors:
• **NAAMAN, Ron**
  **76310 Rehovot (IL)**
• **CARMELI, Itai**
  **Tel Aviv 64925 (IL)**
• **LEITUS, Grigorii**
  **Rishon Le-zion 75271 (IL)**
• **REICH, Shimon**
  **Rehovot 76100 (IL)**
• **VAGER, Zeev**
  **Rehovot 76302 (IL)**

(74) Representative: **Modiano, Micaela Nadia**
**Modiano Josif Pisanty & Staub Ltd**
**Thierschstrasse 11**
**80538 München (DE)**

(56) References cited:
**EP-A- 0 561 279**　　　　**WO-A- 02/091384**
**US-A- 5 922 550**　　　　**US-B1- 6 475 808**
**US-B2- 6 340 568**

• **PATENT ABSTRACTS OF JAPAN vol. 018, no. 266 (E-1551), 20 May 1994 (1994-05-20) & JP 06 045142 A (MATSUSHITA ELECTRIC IND CO LTD), 18 February 1994 (1994-02-18)**
• **CARMELI ET AL.: 'Magnetization of chiral monolayers of polypeptide: a possible source of magnetism in some biological membranes' ANGEW. CHEM. vol. 114, no. 5, 01 March 2002, pages 787 - 790, XP002983330**

## Description

### FIELD OF THE INVENTION

This invention relates to a nanoscopic structure and devices utilizing this structure.

### REFERENCES

The following references are considered to be pertinent for the purpose of understanding the background of the present invention:

1. S. A. Wolf et al., Science, V 294, P. 1488 (2001).
2. S. Das Sarma, American Scientist, V 89, P. 516, (2001).
3. H. Ohno et al., JSAP International, No. 5, P. 4 (January 2002).
4. G. A. Prinz, Science, V 282, P. 1660 (1998).
5. U. S. Patent No. 6,249,453 to You et al.
6. U. S. Patent No. 6,355,953 to Kirczenow.
7. U. S. Patent Application Publication No. 2002/0117727 to Engel et al.
8. U.S. Patent Application Publication No. 2002/0064005 to Arasawa et al.
9. U.S. Patent Application Publication No. 2003/0001154 to Epstein et al.
10. U.S. Patent Application Publication No. 2002/0025374 to Lee et al.
11. WO 02/29911 to Slaughter.
12. WO 02/35559 to Engel et al.
13. U.S. Patent Application Publication No. 2002/0158342 to Tuominen et al.
14. Z. Vager et al., Chem Phys., V. 281, P. 305 (2002).
15. K. Ray et al., Science, P. 283, V. 814 (1999).
16. L. Kronik et al., Surface Science Reports, V. 37, P. 1 (1999).
17. F. Meier et al., Phys. Rev. Lett. V. 47, P. 374 (1981); Phys. Rev. Lett. V. 52, P.1152 (1984); G. Borstel et al, Phys. Rev., V.B 26, P. 1148 (1982);
18. R. Naaman et al., J. Phys. Chem. B, V. 102, P. 3658 (1998);
19. W.G.J. Hol et al., Nature, V. 273, P. 443 (1978);
20. C.F.J. Flipse, C.B. Rouwelaar and F.M.F. de Groot, Eur. Phys. J. D 9, 479, (1999);
21. R.A. Serota Solid State Com. 117, 99, (2001);
22. I. Cabria, b. Nonas, R. Zeller and P.H. Dederichs, Phys. Rev. B, 65, 054414, (2002);
23. N. Harrison, Phys. Rev. B, 66, 122101(R), (2002);
24. R. Burioni, D. Cassi and A. Vezzani, J. Phys. A: Math. Gen. 35, 1245, (2002);
25. R. P. Feynman in Statistical Mechanics, PERSEUS BOOKS (1998).

### BACKGROUND OF THE INVENTION

Spintronics, or spin electronics, refers to the technology that offers opportunities for a new generation of devices combining state-of-the-art microelectronics with a magnetic effect that arises from the interaction between spin of a carrier and the magnetic properties of the material [1-3]. Spintronic devices exploit electron spin information, rather than charge, that can be encoded as a particular spin alignment (either "up" or "down") relative to a reference, e.g., an applied magnetic field or magnetization orientation of the material. The spins, being the attribute of mobile electrons, can carry the information along the conductive line. In turn, the information can be read at a terminal.

Spin orientation of conduction electrons survives for a relatively long time (nanoseconds, compared to tens of femtoseconds during which the electron momentum decays). This feature makes spintronic devices particularly attractive for memory storage, magnetic sensor applications, and eventually for quantum information processing and quantum computation where electron spin would represent a bit (usually referred to as a qubit) of information [1-4].

The device of the kind specified that is already in use in industry as a read head and a memory-storage cell is the giant-magnetoresistive (GMR) sandwich structure that includes alternating ferromagnetic and nonmagnetic metal layers [4]. Depending on the relative orientation of the magnetization in the magnetic layers, the device resistance changes from small (parallel magnetizations) to large (antiparallel magnetizations). This change in resistance is used to sense changes in magnetic fields. Another example of the spintronic application is related to tunnelling magneto resistance (TMR) and magnetic tunnel junction (MTJ) devices where the tunnelling current depends on spin orientations of the electrodes. A typical MTJ device includes two magnetic layers separated by an insulating metal-oxide layer. Electrons can "tunnel" through from one layer to the other only when magnetizations of the layers point in the same direction, otherwise the resistance is high.

One of the approaches of the current efforts in designing and manufacturing spintronic devices involves developing new materials and structures that exhibit large carrier spin polarizations. Most efforts in this approach are currently concentrated on inorganic ferromagnetic semiconductors and combinations of semiconductors and ferromagnetic metals [4-12].

There is also growing interest in replacing inorganic spintronic materials with less expensive materials based on polymeric and/or molecular components [13]. Many polymeric and/or molecular materials can be dissolved in solutions and spun into thin film or readily adsorbed into many substrates.

It is customarily assumed that the adsorption process does hot change the magnetic properties of the adsorbed molecules, at least, not in a major way. However, recently it has been shown that the substrate-monolayer system of aminoacid adsorbed on gold has new magnetic properties, resulting from cooperative effects in the closed packed layer [14, 15]. The magnetic behavior was attributed to the molecules being chiral and to their large electric dipole moment.

JP 6,045,142 discloses an organic magnetic film having macroscopic magnetic properties. The molecules constituting the organic magnetic film are fixed directly or indirectly on a substrate by a covalent bond via at least one atom, which is chosen from among Si, Ge, Sn, Ti, Zr, S and C. The organic film has unpaired electrons, which are derived from a metal and/or a free radical. This organic film is constituted of a monomolecular film or is constituted of an accumulated film formed by a method wherein the molecules constituting the organic film are fixed by a covalent bond with an organic internal layer film via at least one atom, which is chosen from among Si, Ge, Sn, Ti, Zr, S and C.

EP 561,279 discloses an organic magnetic film and a method of manufacturing the same. The organic molecules have unpaired electrons attributable to a metal or organic radicals arranged in the chemical adsorption film; since the chemical adsorption film is magnetic, the spin directions are aligned, and a chemically adsorbed organic magnetic film possessing macroscopic magnetism is realized. The disclosed method of manufacturing is performed by contacting the chemically absorbed film with a chemical adsorbent possessing the reactive functional group at its end, so that organic molecules possessing unpaired electrons derived from a metal or radical are oriented forming a magnetic organic film.

WO 02/091384 discloses a memory device with multi-bit memory cells and a method of making the same. The method is realized by using self-assembly to provide polymer memory cells on the contacts to a transistor array. Employing self-assembly produces polymer memory cells at the precise locations of the contacts of the transistor array. The polymer memory cells change resistance values in response to an electric current above a specified threshold value. The memory cells retain the resistivity values over time.

## SUMMARY OF THE INVENTION

There is a need in the art for, and it would be useful to have, a novel nanoscopic structure for use in spintronic devices. The structure of the present invention is characterized by paramagnetic properties and spin selectivity for electron transmission therethrough. The structure of the present invention can be used in a data carrier, a segmented device having spaced-apart segments with magnetic moment, or a spin filter device.

The nanoscopic structure of the present invention is formed by organic molecules adsorbed on and extending from a surface of an electrically conductive film formed of one or more metal containing layers, said organic molecules containing a binding group forming a chemical bond to said surface and forming a self-assembled monolayer on said surface of the electrically conductive film, the structure thereby having paramagnetic properties and spin selectivity for electron transmission therethrough for use in spintronics.

The organic molecules contain a binding group that forms a bond with the electrically conductive material. The organic molecules may for example be bound to the electrically conductive film through carboxylic, phosphates or thiols group. Example of such molecules are thiolated molecules chemically absorbable on a metal surface by forming stable covalent bonds thereto. Examples of the thiolated molecules suitable for the spintronic structure of the invention include, but are not limited to, alkylthiols and polyalanine molecules.

The electrically conductive film can be a single metal layer of a pure material or a combination of several metal sublayers, where each sublayer is made of a pure material. Examples of the material of the metal film include, but are not limited to, gold, aluminium, copper, chromium and nickel. Alternatively, the metal film can be made of a metal alloy. The metal film may be formed on any insulating or semi-insulating substrate.

The nanoscopic structure of the present invention is characterized by paramagnetic properties. For example, at a field of about 2000 *Oe*, a moment of about 10 Bohr magnetons is observed per adsorbed molecule. The magnetization of the structure of the invention shows a narrow hysteresis loop.

The present invention also provides a data carrier utilizing the above-described structures. According to one non-limiting example, the data carrier is designed like a ROM (read only memory) and includes a substrate on which a bit structure is arranged, being in the form of spaced-apart cells (pattern), each organized in the form of the nanoscopic structure of the invention. For example, a binary "1" can be represented by the cells, which have magnetic moment, while intervals between the cells, which do not have magnetic moment, representing a binary "0". This data carrier can be manufactured by patterning the electrically conductive film on the substrate to form spaced-apart regions of the film in accordance with information to be stored in the data carrier, and then adsorbing organic molecules to the film surface. Information can be read by a suitable reading head, including, for example, a magnetically soft electromagnet (magnetosensor), during a relative displacement between the magnet and the data carrier. The magnitude of the current flowing in the reading head will be indicative of the stored information.

According to another example, the data carrier is in the form of the single structure according to the invention (i.e., an electrically conductive film with the organic molecules absorbed to the film surface) designed as a ROM or recordable memory. In this case, information is recorded in the data carrier by magnetizing selective regions of the structure thereby creating a pattern of spaced-apart regions having magnetic moment spaced by the regions of the structure having no magnetic moment. The recorded information can be read out either by a magnetosensor or by propagating electrons with polarized spin through the structure.

The structure of the present invention can have large spin selectivity for transmission of electrons parallel to the layer in the metal film, which property can be used to fabricate a spin filter device. The device uses the above-described nanoscopic structure, and a source of magnetic field operable for aligning spins of the electrons in the metal film. For example, the metal film is a thin gold film having a thickness in the nanoscopic range, of about 10 nm. The monolayer, for example, is formed of organic thiolated molecules. The source of magnetic filed can, for example, be in a form of a ferromagnetic layer arranged near a second surface of the metal film.

In an ordinary electric current, the spins point at random and play no role in determining the resistance of the material through which they flow. When such a current passes through spin filter device, electrons with the spins, which are not parallel to the magnetization of the metal film, tend to be obstructed. The result is a spin-polarized current in which all the electron spins point mostly in the same direction. The degree of the spin polarization and thereby the electrical resistance of the device can be controlled by variation of the magnitude of the magnetic field.

Thus, according to one broad aspect of the present invention, there is provided a nanoscopic structure comprising organic molecules absorbed on and extending from at least a portion of a surface of an electrically conductive film, wherein said organic molecules contain binding a group forming a chemical bond to said surface and form a self-assembled monolayer on said surface, the structure thereby presenting a paramagnetic and spin selective material for spintronics.

According to another broad aspect of the present invention, there is provided a data carrier comprising a substrate whose surface is patterned to form first data regions spaced from each other by second data regions of the substrate, wherein each first data region presents a paramagnetic material including an electrically conductive film on the surface of the substrate and organic molecules absorbed on and extending from said film, said organic molecules containing a group forming a chemical bond to said film and forming a self-assembled monolayer on said film.

According to yet another broad aspect of the present invention, there is provided a device comprising a nanoscopic structure formed by an electrically conductive film and organic molecules absorbed on and extending from the surface of said film, said organic molecules containing a binding group forming a chemical bond to said surface and forming a self-assembled monolayer on said surface, the device thereby enabling selective magnetization of regions of said structure to form a pattern including spaced-apart regions of the structure having magnetic moment spaced by the regions of the structure with no magnetic moment.

According to a yet another broad aspect of the present invention, there is provided a spin filter device a spin filter device for producing a spin-polarized current, the device comprising:

a spintronic structure comprising organic molecules absorbed on and extending from at least a portion of a surface of an electrically conductive film, wherein said organic molecules contain a bonding group forming a chemical bond to said surface and form a self-assembled monolayer thereon;
a source of magnetic field arranged near said film and operable for aligning spins of the electrons in the film; and
a pair of terminals distant from each other and coupled to said film, the terminals being arranged for allowing an electric current passage therebetween.

According to yet another aspect of the invention, there is provided a method for fabricating a paramagnetic and spin selective material for spintronics, the method comprising selecting organic molecules containing a binding group forming a chemical bond to the surface of an electrically conductive film, and absorbing the organic molecules absorbed on the surface of said such that the absorbed organic molecules extend from said surface, thereby creating a nanoscopic structure formed by a self-assembled monolayer of said molecules on said surface.

There has thus been outlined, rather broadly, the more important features of the invention in order that the detailed description thereof that follows hereinafter may be better understood. Additional details and advantages of the invention will be set forth in the detailed description, and in part will be appreciated from the description, or may be learned by practice of the invention.

## BRIEF DESCRIPTION OF THE DRAWINGS

In order to understand the invention and to see how it may be carried out in practice, a preferred embodiment will now be described, by way of non-limiting example only, with reference to the accompanying drawings, in which:

**Fig. 1** is an enlarged cross-sectional view of a nanoscopic structure according to an exemplary embodiment of the invention;

**Figs. 2A-2D** show the grazing angle IR spectra of the polyalanine monolayers of the nanoscopic structure of the invention;

**Fig. 3** illustrates examples of measurements of magnetization of a nanoscopic structure of the invention constituted of polyalanine chemisorbed on gold;

**Figs. 4A and 4B** exemplify hysteresis loops of the nanoscopic structure of the invention constituted of, respectively, polyalanine chemisorbed on gold and 18-carbon alkylthoil monolayer chemisorbed on gold;

**Fig. 5** illustrates examples of measurements of magnetization of the nanoscopic structure of the invention constituted of polyalanine chemisorbed on gold when the magnetic field was applied perpendicular and parallel to the substrate surface;

**Fig. 6** shows field cooled (FC) magnetization and zero field cooled (ZFC) magnetization vs. temperature for the nanoscopic structure of the invention constituted of two polyalanine monolayers chemisorbed on gold coated silicon;

**Fig. 7** illustrates examples of measurements of magnetization of the nanoscopic structure of the invention constituted of 18-carbon alkylthoil monolayer and ethylthiol chemisorbed on gold;

**Fig. 8** exemplifies a data carrier of the ROM type utilizing the nanoscopic structure of the present invention;

**Fig. 9** exemplifies a device utilizing the structure of the present invention that can be patterned by selective magnetization thereof, thereby enabling the use of the device as a Rom or recordable data carrier;

**Figs. 10A-10D** show several examples of the kinetic energy distributions for photoelectrons transmitted through a monolayer of the nanoscopic structure of the invention;

**Fig. 11** shows an example of the electron transmission spectrum of the nanoscopic structure of the invention obtained at the temperature when the CPD passes through zero;

**Fig. 12** schematically exemplifies a spin filter device according to the invention;

**Fig. 13** schematically illustrates the principles of a model suitable for explaining the phenomenon utilized in the present invention, showing locations of transferred electron on the plane of the positive poles of the attached molecules, away from the molecular electrons; and

**Fig. 14** exemplifies singlet and triplet energies in a 5 Angstrom segment as a function of the effective radius (in Angstroms) of the segment.

## DETAILED DESCRIPTION OF THE INVENTION

The principles and operation of the spintronic structure according to the invention and the devises based thereon may be better understood with reference to the drawings and the accompanying description. It being understood that these drawings and the examples of the measured properties of the spintronic structure are given for illustrative purposes only and are not meant to be limiting. Furthermore, there is no intention to be bound by any theory presented in the references cited the description. The same reference numerals will be utilized for identifying those components which are common in the spintronic structures and devices shown in the drawings throughout the present description of the invention.

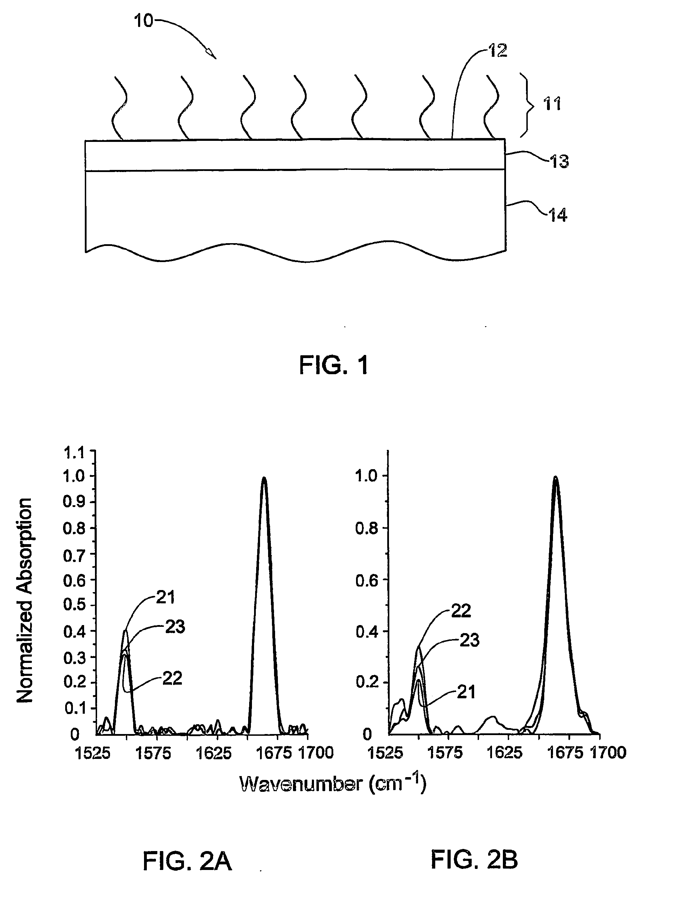

**Fig. 1** illustrates a cross-sectional view of a spintronic structure **10** according to one embodiment of the present invention. It should be noted that this figure is not to scale, and is not in proportion, for purposes of clarity. The structure **10** includes a layer **11** of organic molecules adsorbed on a surface **12** of an electrically conductive film **13**. Preferably, the organic molecules have substantially the same length. The molecules extend (stick out) like bristles from the surface **12** of the conductive film **13,** and form a self-assembled monolayer on the conductive film **13**. It should be noted that, when required, more than one self-assembled monolayer can be formed on the conductive film **13**. The layer **11** can be formed of organic molecules functionalized with a group forming a bond to the electrically conductive surface **12.** The film **13,** which is preferably a metal film, may be formed on a substrate **14,** such as silicon or GaAs or any other insulating or semi-insulating material. The organic molecules are bound to the film **13** through carboxylic, phosphates or thiols group.

Preferably, the organic molecules are thiolated molecules chemically adsorbed on the metal surface **12** by forming stable covalent bonds thereto. According to one example, the thiolated molecules suitable for the structure **10** can be alkylthiols. Depending on the required properties, the number of the alkyl groups in the molecules can be in the range of 2 to 30. According to another example, the thiolated molecules suitable for the structure **10** can be polyalanine bound to the surface of the metal film **13** through a cystine group. Depending on the required properties of the structure, the number of the peptide groups in the polyalanine molecules can be in the range of 1 to 50.

The metal film **13** can be a single metal layer of a pure material or a combination of several metal sublayers, where each sublayer is made of a pure material. Examples of the material of the metal film **13** include, but are not limited to, gold, aluminium, cupper, chromium and nickel. Alternatively, the metal film **13** can be made of a metal alloy. The thickness of the metal film is in the nanoscopic range, for example of about 10nm.

The inventors have studied magnetic induced molecular orientations in a monolayer composed of chiral molecules, and found out that the molecular orientations in the monolayer depend on the handedness of the chiral molecules, as well as on the direction of the molecular dipole moments relative to a metal layer underneath the monolayer. More specifically, self-assembled monolayers of either L or D polyalanine polypeptides in the form of a helices were prepared on a gold layer, and the orientation of the molecules was monitored by IR spectroscopy. The IR spectra of the polyalanine monolayers were measured at magnetic field strengths of 0, $\pm 900$, and $\pm 4500$ Gauss applied perpendicular to the layer. Henceforth, "North" indicates magnetic field lines starting at the North Pole and penetrating through the gold surface to the monolayer, and *vice versa* for "South". The monolayers of either L or D polyalanine polypeptides were prepared on glass slides coated with 100nm thick annealed gold film. By connecting a sulfide group either at the C- or N- terminal of the peptide, the dipole moment of the attached molecules is pointed either away from the substrate or towards the substrate. Three types of the monolayers were investigated: two of poly L-alanine and poly D-alanine, both chemically bound to the gold surface through a sulfide group at the C-terminal of the peptide (referred to as LC and DC respectively), and one type of poly D-alanine, chemically bound to the surface at the N-terminal (referred to as DN). Polypeptide lengths between sixteen and twenty-two amino acid units were used.

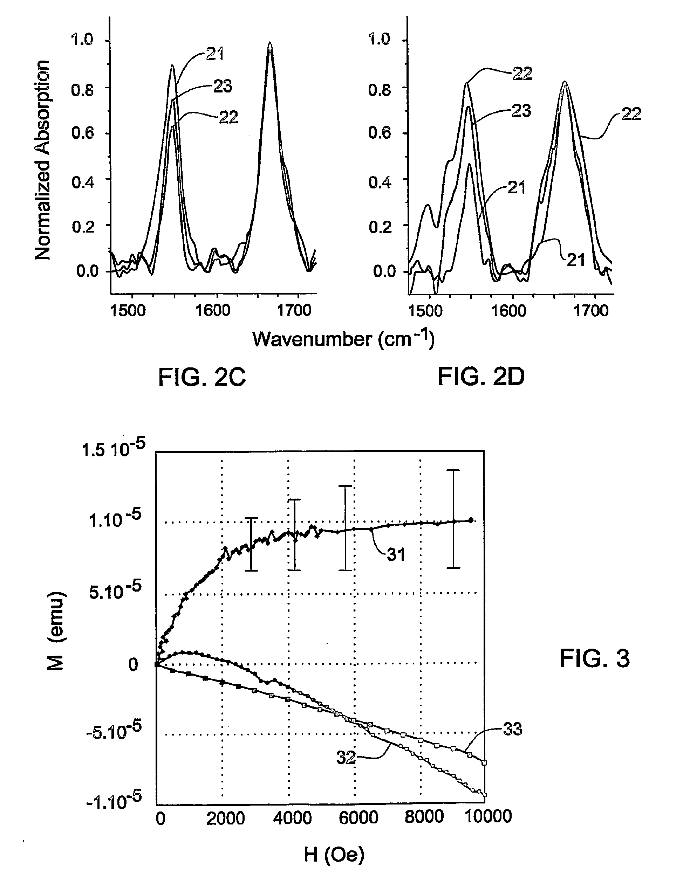

**Figs. 2A-2D** show the grazing angle IR spectra of the polyalanine monolayers of L and D molecules bound to the gold surface through the C-terminal obtained at 297K. The amide I and amid II bands are shown at about 1665 cm$^{-1}$ and 1550 cm$^{-1}$, respectively. The spectra are normalized at the peak of the 1665 cm$^{-1}$ line. The spectra were taken with a magnet having its North pole pointing towards the monolayer (line **21**), with a magnet having its South pole pointing towards the monolayer (line **22**), and without any magnetic field (line 23). The spectra shown in **Fig. 2A** and **Fig. 2B** were taken with a magnetic field of 900Gauss, and spectra shown in **Fig. 2C** and **Fig. 2D** were taken with 4500Gauss. Figs. 2A and 2C correspond to the spectra of D layers, and Figs. 2B and 2D correspond to those of L layers.

The amide I vibration is parallel to the molecular axis (at about 1665cm$^{-1}$), while the amide II vibration at about 1550cm$^{-1}$ is perpendicular to the axis. When the molecules are oriented normal to the surface, the intensity of the amide II component vanishes, because of the metal substrate cancelling the transition dipole moment. Hence, the ratio between the intensity of the two peaks can provide a direct measure of the tilt angle of the molecules relative to the surface normal.

As can be clear from **Figs. 2A-2D,** there is an effect of the magnetic field on the relative intensities for both LC and DC layers. For the two LC layers (Figs. 2B and 2D) the South fields increase the average tilt angles, while the North fields decrease them. The reverse is true for the DC layers (Figs. 2A and 2C); namely, the South fields decrease the average tilt angles, while the North fields increase them. Larger fields show larger tilt deviations. In the present example, it took about 2 to 6 hours for the effect of the magnetic field on the tilt angle to reach its equilibrium. Generally, this time depends on the strength of the magnetic field and on the quality of the monolayer. Namely, the time depends on the packing density of the layer and on the size of the average tilt angle. Better quality layers require more time for equilibrium in magnetic fields. As can be understood, these magnetic field orientation effects within the layers provide are indicative of that the films have magnetic properties and that opposite magnetization occur for different handedness.

**Fig. 3** illustrates examples of measurements of magnetization $M$ (curve **31**) of the spintronic structure of the present invention prepared in the shape of a bare silicon substrate coated with the gold film which, in turn, is coated with a self-assembled monolayer of polyalanine molecules chemisorbed. The measurements were carried out at 300K. The magnetic field $H$ was applied perpendicular to the substrate surface. As a reference, Fig. 3 also shows the measurements of magnetization $M$ (curve **32**) of the silicon substrate directly coated with a layer of polyalanine (i.e., with no gold film between them), and the measurements of magnetization $M$ (curve **33**) of the silicon substrate coated with the gold having no polyalanine on its surface. The measurements were carried out with a superconducting quantum interference device (SQUID) magnetometer.

As can be seen from the behavior of the curves **32** and **33,** both the silicon substrate coated with gold (no polyalanine) and the silicon substrate coated with the physisorbed layer of polyalanine (no gold layer) show diamagnetic responses. This is indicative of an insignificant amount of paramagnetic impurities. However, when the polyalanine is chemisorbed on the gold layer (curves **31**), a positive susceptibility is measured. In other words, the structure of the present invention shows paramagnetic properties. Typically, at a field of about 2000 $Oe$, a moment of about 10Bohr magnetons is observed per adsorbed molecule.

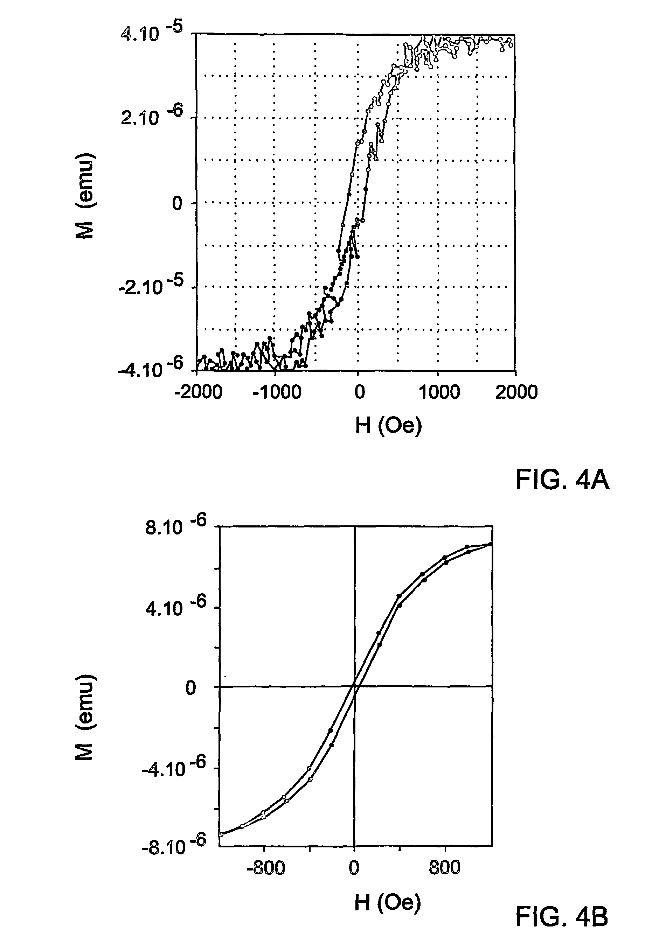

Referring to **Figs. 4A and 4B,** hysteresis loops of two examples of the structure of the present invention are shown. In the example of Fig. 4A, the structure is constituted of polyalanine monolayer chemisorbed on gold is illustrated, and in the example of Fig. 4B the structure is constituted of 18-carbon alkylthoil monolayer chemisorbed on gold. The measurements were carried out at 300K. The magnetic field direction was perpendicular to the monolayer during the magnetization measurements. As can be seen, the magnetization shows narrow hysteresis loops with a width of about 50 $Oe$ in the example of Fig. 4A and of about 20Oe in the example of Fig. 4B.

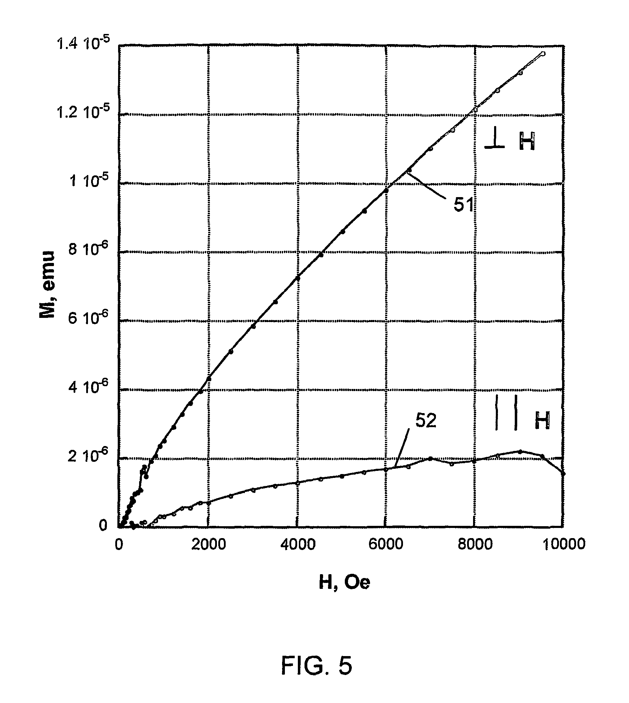

**Fig. 5** illustrates examples of measurements of magnetization *M* of the structure of the present invention constituted of polyalanine monolayer chemisorbed on gold surface when the magnetic field *H* was applied perpendicular (curve **51**) and parallel (curve **52**) to the monolayers. The measurements were carried out at 300K. As can be seen, the magnetic response is relatively weak when the magnetic field is applied parallel to the substrate surface, which is indicative of a large anisotropy of magnetization.

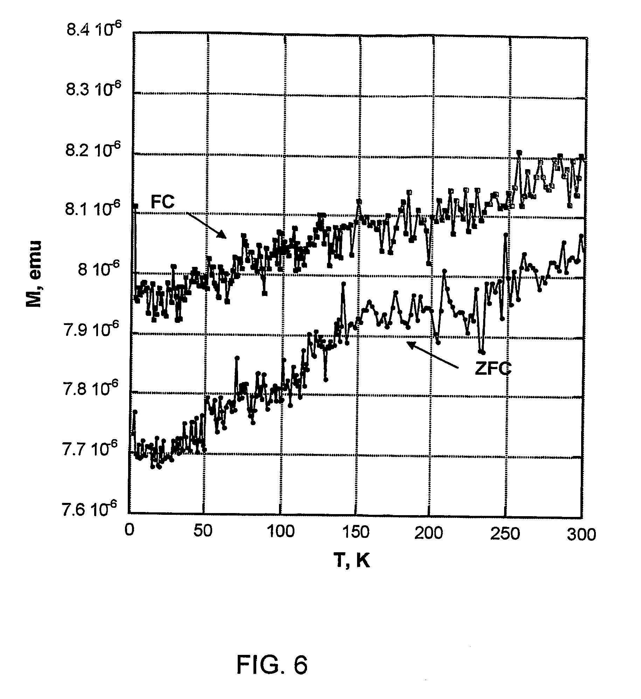

Measurements of magnetization of the structure of the present invention constituted of polyalanine chemisorbed on gold as a function of temperature are shown in **Fig. 6**. The field cooled (**FC**) magnetization and zero field cooled (**ZFC**) magnetization were measured when the magnetic field was applied perpendicular to the structure. As can be seen, no significant temperature changes are observed in a temperature range of about 1K to 300K. This indicates that the spintronic structure can operate in a rather broad temperature range without changes of magnetization. In other words, the magnetization properties of the structure are substantially insensitive to temperature changes.

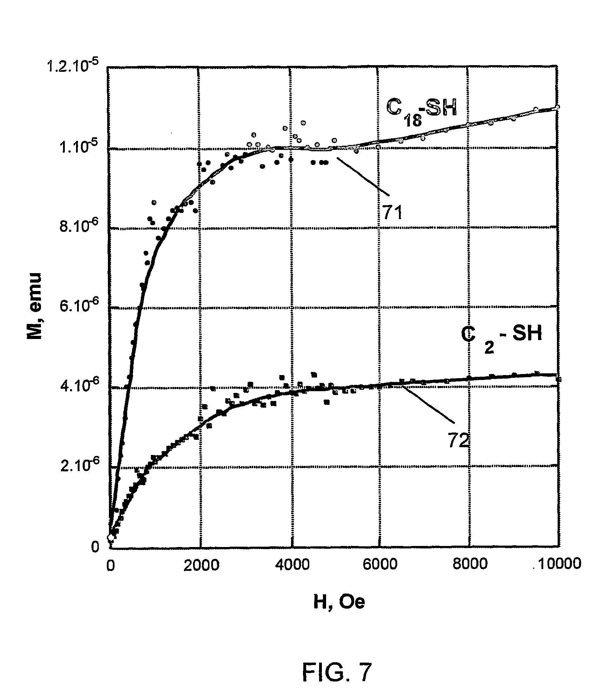

Referring to **Fig. 7**, there are illustrated examples of measurements of magnetization *M* of the structure of the present invention constituted of 18-carbon alkylthiol (curve **71**) and ethylthiol (curve **72**) monolayers chemisorbed on gold surface. The measurements were carried out at 300K. The magnetic field *H* was applied perpendicular to the monolayers. The measured magnetic responses are similar for polyalanine and alkylthoil, though weaker for alkylthiols compared to samples with polyalanine. The smallest magnetization is observed in the monolayer made from ethylthiol chains.

The magnetic properties of the nanoscopic structure of the present invention can be used for creating a data carrier, of either ROM or recordable type.

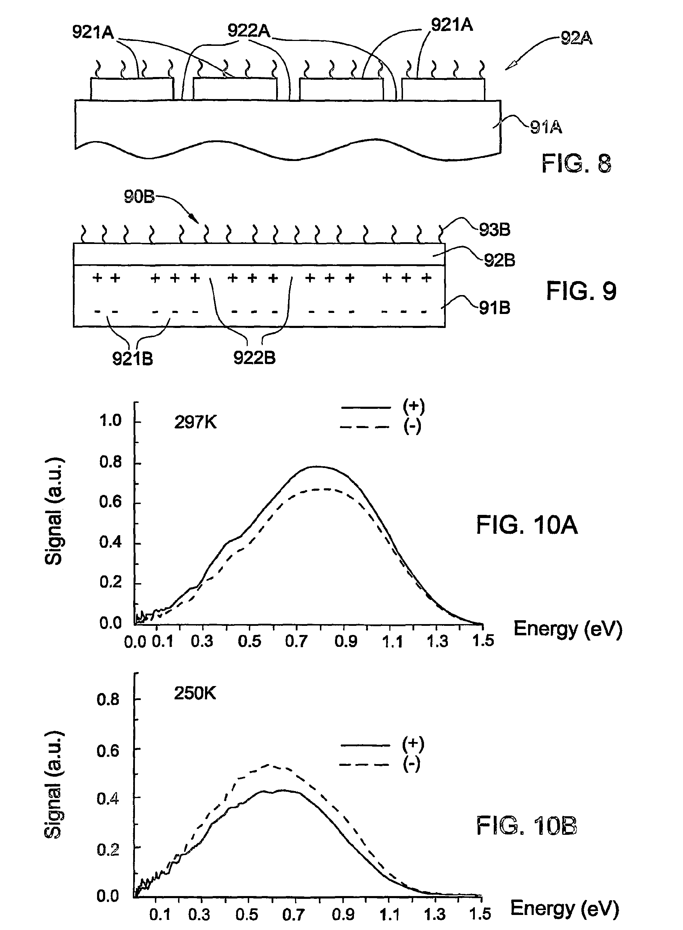

**Fig. 8** exemplifies a data carrier **90A** according to the invention. In the present example the data carrier is of the ROM type, and includes a substrate **91A** on which a bit structure **92** is arranged being formed by an array of spaced-apart nanoscopic regions (cells) **921A** each designed as the structure the present invention (**10** in **Fig. 1**) having paramagnetic properties. For example, a binary "1" can be represented by cells **921A,** and intervals **922A** between the cells **921A,** which have diamagnetic properties of the substrate **91A,** can represent a binary "0". In other words, in the device **90,** the data layer is formed by first data regions **921A,** each being the structure of the present invention, arranged in a spaced-apart relationship defining second data regions **922A** of the common substrate **91A** between the regions **921A**.

The data carrier **90A** can be fabricated by depositing the electrically conductive layer on the substrate, patterning the electrically conductive layer by removing the layer material in regions **922A,** and then absorbing organic molecules to the electrically conductive regions **921A**. Information stored in the data carrier **90A** can be read by a reading head of the kind sensitive to a magnetic field, while providing a relative displacement between the reading head and the data carrier **90A**. For example, the reading head may include a magnetically soft electromagnet. The magnetic properties of the structure thus affect the magnitude of the current flowing in the reading head, and changes in the current are indicative of the stored information.

**Fig. 9** exemplifies a device **90B** utilizing the structure of the present invention such **10** in Fig. 1 patterned to form an array of spaced-apart segments of the structure having magnetic moment spaced by segments of the structure having no magnetic moment. The device **90B** includes a substrate **91B** of insulating or semi-insulating material, on top of which the structure **10** of the present invention is formed, namely, an electrically conductive layer **92** with a monolayer **93** of organic molecules on its surface. The structure **10** has an array of magnetized regions **921B,** i.e., having a magnetic moment, and regions **922B** with no magnetic moment in the spaces between the regions **921B**. Such a pattern can be created by appropriately scanning the structure **10** with a magnet, or placing a magnet adjacent to the structure and accommodating a grating (i.e., mask having regions allowing the magnetic field propagation therethrough spaced by regions screening the magnetic field) between the magnet and the structure **10**.

The device **90B** can, for example, serve as a data carrier. Information can be recorded in the device **90B** by creating a pattern in the form of an array of spaced-apart segments **921B** of the structure having magnetic moment spaced by segments **922B** that do not have magnetic moment. The stored information can be read out by irradiating the data carrier with spin polarized electrons and measuring the transmission of electrons.

The following are experimental results demonstrating the electron transmission through the structure of the present invention, and the spin selectivity for electron transmission parallel to the layer in the metal film.

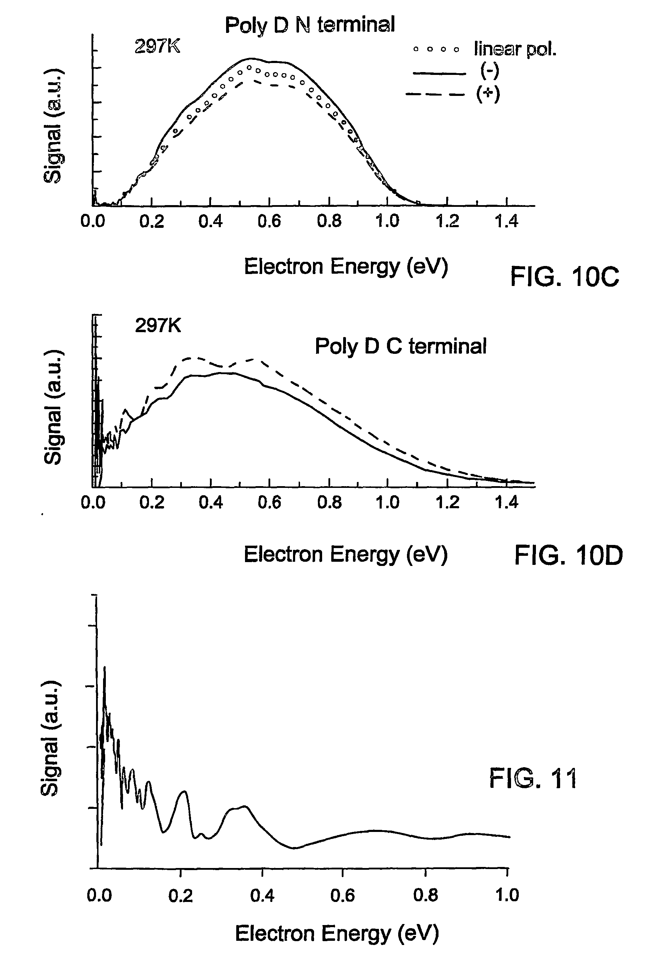

**Figs. 10A-10D** show the kinetic energy distributions for photoelectrons ejected with a left (negative spin polarization, solid line) or right (positive spin polarization, dashed line) circular polarized laser operating at 248 nm (hv=5.0eV). The electrons are transmitted through a monolayer of L-polyalanine bound to the gold surface through the carbon terminal (Figs. 10A, 10B), through a monolayer D-polyalanine bound to the gold surface through the carbon terminal (Fig. 10D), and through a monolayer of D-polyalanine bound to the surface through the N-terminal (Fig. 10C). The spectra shown in Figs. 10A, 10C and 10D were recorded at 297K, while the spectra shown in Fig. 10B were recorded at 250K.

The asymmetry parameter was calculated as:

$$A = \frac{I(+P) - I(-P)}{I(+P) + I(-P)}$$

where $I(+P)$ and $I(-P)$ are the transmissions of the electron beam with spin angular momentum oriented parallel (positive spin polarization $+P$) and antiparallel (negative spin polarization $-P$) to its velocity vector.

The measurements of the transmission through a monolayer of L-polyalanine and D-polyalanine at 297K show that the sign of the asymmetry depends on the handedness of the molecules. As can be understood from Figs. 10C and 10D, for a given handedness of the molecules, the sign of the asymmetry switches upon reversing the way the molecules are adsorbed on the surface (from N to C terminated molecules). The observed asymmetry in the transmission through the layers of photoelectrons produced by left and right circular polarization of photons changes from $0.09 \pm 0.02$ to $-0.10 \pm 0.02$, respectively. By the same token, the measurements of the transmission through a monolayer of L-polyalanine at different temperatures shows that the observed asymmetry in the transmission of photoelectrons produced by left and right circular polarization of photons changes from $0.09 \pm 0.02$ to $-0.11 \pm 0.02$ (Figs. 10A and 10B, respectively). The inventors have developed a simple physical model compatible with the described observation of the electron transmission that predicts the direction of magnetization. According to this model, upon adsorption of polyalanine molecules to the gold surface, a transient current appears through the helix, which discharges the electric dipole while inducing magnetism, like a classical electro-magnetic coil. The spins of simultaneously created unpaired electrons adjust accordingly and stay polarized by support of exchange forces with the metal and the already polarized electrons of attached neighbor helices. The result of such an adsorption mechanism is a magnetic layer where the direction of the magnetic field is given by Ampere's law. For each adsorbed helix, the original electric dipole polarity and the handedness of the helix determine the direction of the magnetic field along the helix axis. As described above, the helix axes of the polyalanine molecules may not be well aligned normal to the surface. Therefore, when an external magnetic field is applied in the normal direction, it forces these axes to get either closer to normal or away from it, depending on the direction of the external magnetic field.

**Fig. 11** shows an example of the electron transmission spectrum of the spintronic structure of the invention obtained at the temperature 264K, when the CPD passes through zero. Zero magnitude of the CPD indicates that the layer's electric dipole moment has vanished. Several sharp resonances are observed and no spin selectivity exists at this temperature. The spacing of the resonances, as well as their width, are largely determined by the width of the layer and not by the negative ion resonances of the adsorbed molecules. The peaks in the graph, in order of increasing energy, correspond to solitons with 1,2,... nodes within the layer. These resonances corresponding to the solitons do not exist when the CPD is slightly away from zero, namely, when there is a dipole on the layer. Specifically, the resonances are observed at the range of about $(264 \pm 5)$K which corresponds to a range of CPD of $(0 \pm 0.06)$V, and disappear elsewhere. The disappearance of the resonances upon existence of a dipole moment is an indication of a different mode of transmission through the layer.

The spin selectivity characteristics of the nanoscopic structure of the invention provides a possibility of developing spin-polarized conducting devices that can act as a filter, or spin valve, changing their resistivity for electrons of a specific spin polarization. Spin filters and valves could be used, *inter alia*, in spintronic transistors.

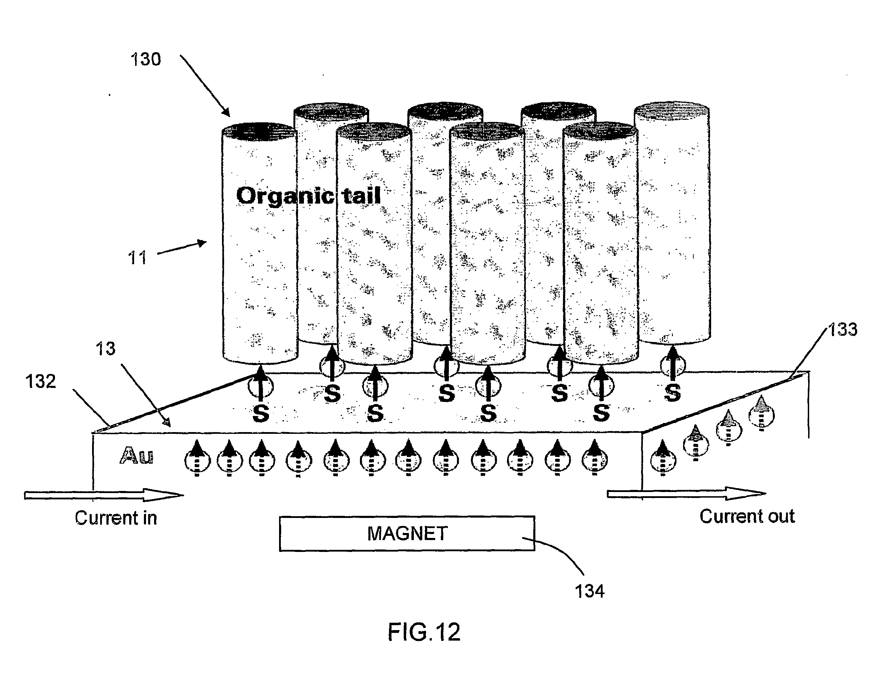

**Fig. 12** exemplifies an enlarged cross-sectional view of a spin filter device **130** that uses the structure of the present invention. The spin filter device **130** thus includes a metal film **13** with a self-assembled monolayer **11** chemically adsorbed on a surface **131** of the film **13,** and includes a pair of terminals **132** and **133** distant from each other and coupled to the metal film **13**. The spin filter device **130** further includes a source of magnetic field **134** (magnet) operable to align spins **S** of the electrons in the metal film **13**. It should be appreciated that the degree of spin alignment depends on both the strength of the magnetic field **H** and the type of the organic molecules forming the monolayer **11.** For example, the metal film is a thin gold film having a thickness in the range of 1-10nm, preferably about 5nm. The monolayer **11,** for example, is formed of organic thiolated molecules. The source of magnetic field **134** may be in a form of a ferromagnetic layer arranged near the surface of the metal film **13** opposite to that carrying the monolayer.

Spin filtering can be carried out in either direction between the terminals **132** and **133**. In an ordinary electric current, the spins point at random and play no role in determining the resistance of the material through which they flow. When such a current $I_{in}$ passes between the terminals **132** and **133** through the spin filter device **130,** electrons, which have spins not parallel to the magnetization of the metal film **13**, tend to be obstructed. The result is a spin-polarized current $I_{out}$ in which all the electron spins point mostly in the same direction. It should be appreciated that the degree of the spin polarization and therefore the electrical resistance of the device can be controlled by variation of the magnitude of the magnetic field.

The giant magnetization which was observed in organic monolayers made from diamagnetic molecules adsorbed on diamagnetic substrates can be explained using a model based on the special properties of electrons transferred from the substrate to the layer as a result of the adsorption process. Triplet pairing of these electrons is forced by the special 2D properties of the organic layer. Such pairs are confined within domains in the organic layer, and their quantum statistics provide a model that explains the unique magnetization as well as all other features of the experimental observations. The model suggests possible existence of Bose-Einstein condensation at room temperature on the scale of the domains.

It appears that, when certain organic molecules are self-assembled as monolayers on solid substrates. The inventors have observed this type of magnetism for organic thiols adsorbed on gold and organic acids adsorbed on GaAs surfaces. Some of the films studied show very high specific magnetization, up to hundreds of Bohr magnetons per adsorbed molecule, with no saturation up to a field of one Tesla.

The magnetic susceptibility is highly anisotropic with a highest response along the axis perpendicular to the surface and shows almost no temperature dependence down to few degrees Kelvin. The organic layers for which magnetization was observed are characterized by a transfer of electrons from the substrate to the layer occurring upon adsorption. This is due the magnetization of hundreds of Bohr magnetons per adsorbed molecule. This phenomenon can be explained by both the size of magnetism and the large anisotropy point to surface orbital magnetism [20-23]. Simple orbital magnetism would, however, require angular momenta of several hundreds for electrons within molecules, thus necessitating inconceivably high kinetic energy (e.g., about 400eV for $l$=100 state with molecules of 1nm radius).

The model exemplified below deals with some special physical properties of the electrons that were transferred from the substrate and reside on the layer. It is shown that the lowest energy state of these electrons is reached by pairing to triplets, namely forming boson pairs. Such pairs are confined within domains in the organic layer. Their quantum statistics as triplet bosons provides the model that explains the experimental observation.

The organic monolayer can be imagined as a 2D lattice of dipolar amphiphilic molecules adsorbed on a metal substrate, so that all the positive poles point away from the substrate. These molecules are typically long with their long axis almost perpendicular to the substrate. The inventors have found that in the adsorption process, electrons from the metal are transferred to the layer and neutralize the positive poles, thus, drastically reducing the large electrostatic energy of the dipole layer. This process results in a very thin reversed dipolar layer on the interface between the substrate and the organic layer with substantially reduced free energy. The gain in energy due to the transfer of a single electron per molecule can be up to several tens of $eV$. The topology of such 'brush' like structures was suggested to induce low dimensional electronic Bose-Einstein condensation [24].

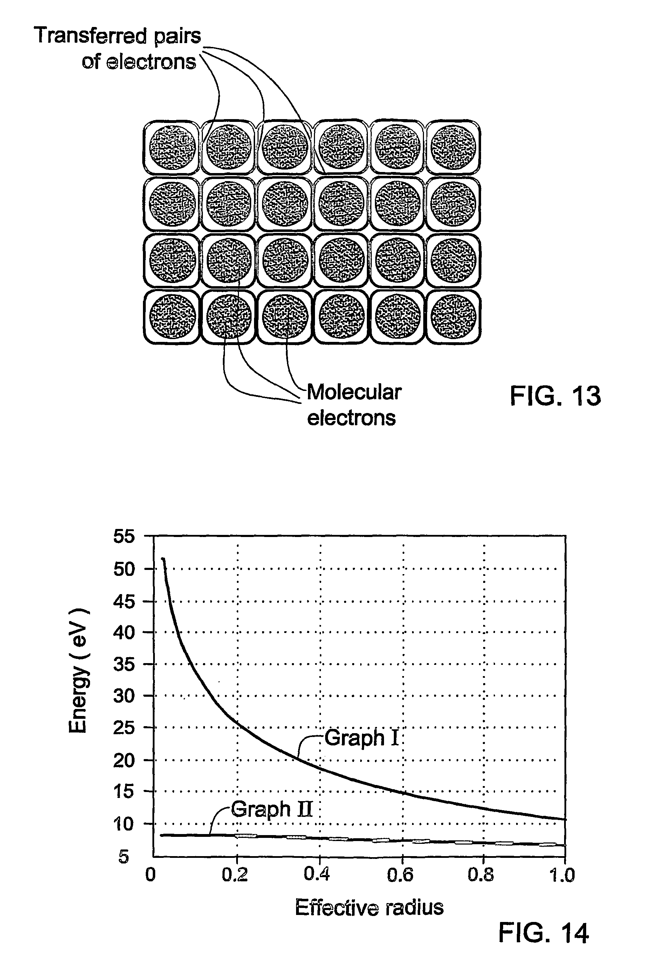

Since the molecules are originally with 'closed-shells' and have typically low electron-affinity, the transferred electrons necessarily occupy negative ion states which are with large radius around the long molecular axis. In particular, for the organized monolayer, the Pauli principle excludes their location near the molecular axes. Thus, as schematically illustrated in **Fig. 13**, these transferred electron are "squeezed" on a two dimensional network of borders between the molecules. They reside in the vicinity and on the plane of the positive poles. The model described below is based on the nature of this network of transferred electrons.

Assuming a single transferred electron for each attached molecule, a 2D lattice could be considered with a single molecule at each unit cell. The effective single electron periodic potential must include large exchange terms due to the virtually overlap of electrons on the borderlines of the cells. To explicitly include such terms, a larger unit cell should preferably be considered which includes $2N$ transferred electrons and $2N$ molecules. A reasonable approximation is to add an additional repulsive energy, $E_r$, to the binding of each molecule due to the pair of overlapping electrons on the borderlines, as shown in Fig. 13. The electrostatic repulsion between these two border-squeezed-electrons favors the triplet configuration for each such pair of electrons. This is because the triplet amplitude vanishes smoothly at zero distance between the electrons. The corresponding zero amplitude of the singlet is at finite separation between the electrons.

**Fig. 14** shows the calculations of $E_r$ for a single (Graph I) segment of intermolecular dimension and for triplet (Graph II) at different (narrow) effective radii along the borderline. As shown, the singlet state is higher in energy than the triplet state by many $eV$. It should be understood that this system is different from any common bond in a molecular system. Here, the transferred electrons must reside between the molecules, while in a typical molecular bond only a small portion of the total charge is located on the bond between the nuclei. This difference causes the triplet state to be the ground state here, while in many molecular systems the singlet is the ground state. Hence, the adoption of the transferred electrons configuration of Fig. 13 forces a paired electrons many body (of transferred electrons) state. Namely, to a good approximation, the many body state is of bosons. As such, the minimal 2D unit cell is of two molecules and Bloch single boson solutions are appropriate. Thus, the periodic solution within a cell of the various order parameters is accompanied with almost continuous phases along the 2D space, allowing for low energy collective phenomena.

The number of triplet pairs is half the number of attached molecules (on the order of $10^6 \mu^{-2}$). The connectivity of pairs amplitude along the border lines between molecules ensures a long range spin magnetism with a very high critical temperature. The planarity suggests a preferred direction, $z$, which is chosen to be perpendicular and pointing away from the substrate. Experimentally, domains are formed during the adsorption process with dimensions between $0.05 \mu m$ - $1 \mu m$. Assuming that the shape of the domains is molded by the chemistry of attachment and once the molecules are adsorbed, the domains do not change upon cooling or upon changing magnetic field, within each domain the spin direction is highly correlated.

Beyond the spin, another degree of freedom of each pair of electrons is the orbital angular momentum $l$. The requirement for anti-symmetry for a pair of triplet electrons allows only for odd integers: $l = 1, 3,....$ Assuming non-interacting bosons on a circular domain, the lowest energy modes associated with the internal angular momentum degree of freedom of the electron-pairs are a discrete set of 'drum' modes. These include angular momentum modes with energies which correspond to rotations around the domain axis.

Considering an effective magnetic field $H$ perpendicular to the surface, this magnetic field is composed of an external field and the internal field due to average neighboring magnetization. The energy of a single pair of electrons in the effective magnetic field, within a domain of radius $\xi$ and area $A = \pi\xi^2$, is given by the eigenvalues of the following Hamiltonian:

$$H = T + \mu_B l_z H \qquad (1)$$

where $\mu_B$ is the electronic magnetic moment - Bohr magneton, and $T$ is the kinetic energy, with $l$ dependent energies:

$$E_l(H) = \frac{h^2 l^2}{4m_0\xi^2} + \mu_B l H = \frac{h^2}{4m_0\xi^2}[(l-\lambda)^2 - \lambda^2] \qquad (2)$$

where $\lambda$ is the classical angular momentum that minimizes the energy. Defining an energy factor (domain's rotational constant):

$$\varepsilon = \frac{h^2}{4m_0\xi^2} \qquad (3)$$

there are various ways to express $\lambda$, such as

$$\lambda = -\frac{\mu_B H}{2\varepsilon} \qquad (4)$$

and

$$\lambda = -2\frac{AH}{\Phi_0} = -2\frac{\Phi}{\Phi_0} \qquad (5)$$

with $\Phi_0 = \frac{hc}{\varepsilon}$. The physical minimum energy is at an odd integer $l_\lambda$ which is closest to $\lambda$. When the .flux in the domain changes by one unit of $\Phi_0$, the ground state angular momentum of each triplet pair changes by two.

When $H_T$ is the field in Tesla and $\xi_\mu$ is the radius of the domain in microns then:

$$|\lambda| = 1520\, H_T\, \xi_\mu^2 \qquad (6)$$

Hence, in the presence of a magnetic field, each tripletpair boson possesses an extraordinarily high angular momentum. For a given domain size, the effective magnetic field defines a ground state with an odd internal angular momentum $l_\lambda$ for the triplet pairs, so that $l_\lambda$ is as close as possible to $\lambda$. The parameter $\lambda$.is proportional to the effective magnetic field and the area A of the domain (Eqs. (4,5)).

In view of the above and according to Eq. (6), the average contribution of each triplet pair to the magnetization is $\lambda$ Bohr magnetons, assuming a unit g-factor for electronic orbital motion.

Any number of bosons can occupy each state of the transferred electrons within a domain provided that the total number of bosons is half the number of transferred electrons within that domain. Therefore, the free energy in a domain is given by [25]:

$$g = \beta^{-1}\sum_l \ln(1 - e^{-\beta(E_l - \mu)}) \qquad (7)$$

where $\mu$ is the chemical potential - corresponding to the average number - (N) - of triplet pairs in the domain:

$$(N) = -\frac{\partial g}{\partial \mu} = \sum_l \frac{e^{-\beta(E_l - \mu)}}{(1 - e^{-\beta(E_l - \mu)})} = \sum_{n=1}^{\infty}\sum_l e^{-n\beta(E_l - \mu)} \qquad (8)$$

Considering the contribution of $n$ - 1 bosons separately:

$$G_n = \sum_l e^{-n\beta(E_l - \mu)} = e^{n\beta(\mu + \varepsilon\lambda^2)}F_n \qquad (9)$$

such that

$$(N) = \sum_{n=1}^{\infty}G_n \qquad (10)$$

and to each $n$ - 1 bosons, the contribution of different angular momenta $l$ is as follows:

$$F_n = \sum_l e^{-n\beta\varepsilon(1-\lambda)^2} \qquad (11)$$

Equation (11) can be approximated using two limits, resulting in two regimes. In the first, the sum over the Gaussian functions can be approximated by an integral, provided that $\sigma > 2$ where

$$2\sigma^2 = (n\beta\varepsilon)^{-1} \qquad (12)$$

with a result

$$F_n = \sqrt{2}\,\pi\sigma \qquad\qquad (13)$$

which is independent of $\lambda$, thus, independent of $H$. Equation (12) defines a critical index:

$$n_c = \frac{1}{8\beta\varepsilon} \qquad\qquad (14)$$

such that for $n < n_c$ the condition $\sigma > 2$ is fulfilled. The critical index can be quantified by:

$$n_c = 570\, T_K \xi \mu^2 \qquad\qquad (15)$$

where $T_K$ is the temperature in Kelvin.

The contribution of $n \leq n_c$ to (N) is given by:

$$(N)_n = \sqrt{8\pi n_c} \sum_{n=1}^{n_c} \frac{e^{n\beta(\mu+\varepsilon\lambda^2)}}{\sqrt{n}} \qquad\qquad (16)$$

Since at a given temperature, many $l$ states contribute to the domain's boson population, this regime is called 'normal' and the participating bosons are referred to as 'normal bosons'. The average number of normal bosons in the domain, $(N)_n$, depends on $H$ only through the chemical potential dependence on $\lambda$, namely $\mu' = \mu + \varepsilon\lambda^2$.

For $\mu' = 0$, the sum in eq. (16) can be approximated by $2\sqrt{\pi n_c}$ which limits $(N)_n$, at low temperatures, to be a negligible fraction of (N).

In the second limit, for $\sigma < 2$, eq. (11) is a sum of almost non-overlapping Gaussian functions. It can be approximated by a single Gaussian where only one $l_\lambda$ contributes. When the ground state is described by a large fraction of bosons occupying a single state, then that fraction is called a condensate. Since for $n > n_c$ all bosons with $l_\lambda$ contribute to the ground state, then, if the corresponding fraction of (N) is significant, a condensate condition is achieved.

For each $n$-1 bosons, the single Gaussian contribution is

$$F_n = e^{-n\beta\varepsilon(l_\lambda-\lambda)^2} \qquad\qquad (17)$$

where $l_\lambda$ is the odd integer which is the closest to $\lambda$. Therefore:

$$G_n = e^{n\beta(\mu+\varepsilon[\lambda^2-(l_\lambda-\lambda)^2])} \qquad\qquad (18)$$

and its sum up to $n \to \infty$ converges only if $\mu < -\varepsilon[\lambda^2-(l_\lambda-\lambda)^2] \leq -\varepsilon\lambda^2$. For $\lambda \gg 1$, $[\lambda^2-(l_\lambda-\lambda)^2]$ can be replaced by $\lambda^2$. Thus, the contribution to (N) by the condensed boson phase is given by:

$$(N)_n = \frac{e^{n_c\beta(\mu+\varepsilon\lambda^2)}}{1-e^{\beta(\mu+\varepsilon\lambda^2)}} \qquad\qquad (19)$$

In each domain, the pairs condense at the corresponding $l_\lambda$ level. The value of $l_\lambda$ increases by two when the flux through the domain changes by $\Phi_0$, and the dependence on $H$ of the average number of condensed bosons is only through $\mu' = \mu + \varepsilon\lambda^2$.

The convergence of $(N)_c$ requires $\mu' < 0$. As mentioned above, under such conditions $(N)_n$ of eq. (16) is limited to much smaller number of pairs than expected for regular domain sizes. This is easily realized for low temperatures. Thus, at room temperature and below, the very existence of a condensate phase requires that most of the available pairs in the domain will be in this state.

The arguments so far indicate that almost all the bosons are in a condensate within each domain. Therefore, to a good approximation, the effective field is simply the external magnetic field. For the magnetic properties, both $(N)_n$ and $(N)_c$ and therefore also the sum $(N) = (N)_n + (N)_c$, depend on the magnetic field only through $\mu' = \mu + \varepsilon\lambda^2$. Since

$$(N) = -\frac{\partial g}{\partial \mu} \qquad (20)$$

then the magnetization of the domain is given by

$$M = -\frac{\partial g}{\partial H} = 2\lambda \frac{\partial \lambda}{\partial H} \varepsilon (N) = -\mu_B \lambda (N) = 2(N)\mu^2{}_B H \frac{m_0}{h^2} \xi^2 \qquad (21)$$

Each pair of electrons contributes $|\lambda|$ Bohr magnetons to the magnetic moment, independently of temperature. This is a direct result of the condensed boson character of the transferred electrons.

The specific magnetization for each molecule in units of Bohr magnetons $M_{Bohr}$ is given by:

$$M_{Bohr} = \frac{1}{2} \frac{\mu_B H}{\varepsilon} \qquad (22)$$

Rather than being a result of competition between the magnetic energy $\mu_B H$ and $kT$, as in ordinary paramagnetic material, here $M_{Bohr}$ is given by the ratio of the electronic magnetic energy and the domain's rotational constant $\varepsilon$. Hence, the average magnetization per molecule depends on the size of the domain.

The system reaches saturation when the maximum angular momentum $l = L_M$, within a domain, is achieved. The maximum depends on the Fermi energy of the electrons in the substrate and is estimated as $L_M \approx 2000\xi_\mu$. Therefore, in a layer with variety of domain sizes, very small domains are saturated at relatively low magnetic fields. This explains the curvature of some magnetization plots obtained for different samples.

Three conditions are required for observing the triplet pairing and its boson condensation consequences. Substantial charge transfer, close packing of the organic molecules in an organized manner and "squeezing" of the extra electrons between the molecules of the organic layer. The last condition means that, in the case of amphiphilic molecules, the head group that binds the molecule to the surface must be of the same size (or smaller) when compared with the "tail". Otherwise, the distance between the tails is relatively large and the transferred electrons are not forced to be in the triplet state.

Thus, the theory of the triplet boson character of the layer of transferred electrons can explain the ex-nihilo magnetization of organic monolayers on solid substrates, its magnitude, anisotropy and temperature independence. The huge paramagnetic character of the transferred electron layer is comparable to the opposite sign diamagnetism of superconductors. In superconductors, the angular momentum of the center of mass motion of Cooper pairs contributes to diamagnetism, while in the present case the internal angular momentum within the pair is responsible for the paramagnetism. The freezing of the center of mass motion of the triplet pairs makes the state of the transferred electrons different from other known condensation phenomena.

Thus, the present invention provides for practical and theoretical considerations allowing for configuring a novel nanoscopic structure that can be used in spintronic devices. This structure is characterized by paramagnetic properties and spin selectivity for electron transmission therethrough. The structure of the present invention can be used in a data carrier, a segmented device having spaced-apart segments with magnetic moment, or a spin filter device.

EP 1 606 215 B1

Those skilled in the art to which the present invention pertains, can appreciate that while the present invention has been described in terms of preferred embodiments, the concept upon which this disclosure is based may readily be utilized as a basis for the designing of other structures, systems and processes for carrying out the several purposes of the present invention.

Although the example of utilization of the nanoscopic structure of the present invention were shown for a data carrier, segmented magnetic structure and filter device, the structure can also be used as components in sensors or as a part of a spintronics circuit.

Also, it is to be understood that the phraseology and terminology employed herein are for the purpose of description and should not be regarded as limiting.

It is important, therefore, that the scope of the invention is not construed as being limited by the illustrative embodiments set forth herein. Other variations are possible within the scope of the present invention as defined in the appended claims and their equivalents.

**Claims**

1. A nanoscopic structure (10) formed by organic molecules adsorbed on and extending from a surface (12) of an electrically conductive film (13) formed of one or more metal containing layers, said organic molecules containing a binding group forming a chemical bond to said surface (12) and forming a self-assembled monolayer on said surface (12) of the electrically conductive film (13), the structure thereby having paramagnetic properties and spin selectivity for electron transmission therethrough for use in spintronics.

2. The structure of Claim 1 wherein said organic molecules have substantially the same length.

3. The structure of Claim 1 wherein said organic molecules are thiolated molecules.

4. The structure of Claim 3 wherein said thiolated molecules are alkylthiols.

5. The structure of Claim 4 wherein the number of the alkyl groups in the alkylthiols can be in the range of 2 to 30.

6. The structure of Claim 3 wherein said thiolated molecules are polyalanine bound to said surface through a cystine group.

7. The structure of Claim 6 wherein the number of the peptide groups in the polyalanine molecules can be in the range of 1 to 50.

8. The structure of Claim 1 wherein said electrically conductive film (13) is a single metal layer of a pure material.

9. The structure of Claim 1 wherein said electrically conductive film (13) is a combination of several metal sublayers, each sublayer being made of a pure material.

10. The structure of Claim 1 wherein said electrically conductive film (13) is made of a metal alloy.

11. The structure of Claim 1 wherein said electrically conductive film (13) is made of a material selected from gold, aluminum, copper, and chromium.

12. The structure of Claim 1 where the molecules are bound to the surface (12) of the electrically conductive film (13) through at least one of the following groups: carboxylic, phosphates and thiols groups.

13. The structure of Claim 1 comprising a substrate (14) carrying said electrically conductive film.

14. The structure of Claim 13, wherein the substrate (14) is a semiconductor.

15. The structure of Claim 13 wherein said substrate (14) is made of insulating or semi-insulating material.

16. The structure of Claim 13 wherein said substrate (14) is made of silicon or GaAs.

17. The structure of Claim 1 wherein thickness of the electrically conductive film (13) substantially does not exceed 50 nm.

**18.** The structure of Claim 17, wherein the thickness of the electrically conductive film (13) is about 1-10 nm.

**19.** A paramagnetic device comprising the structure (10) of any of Claim 1 to 18, the electrically conductive film (13) having a thickness in a nanoscopic range.

**20.** A spin selective material for spintronics comprising the structure (10) of any one of Claim 1 to 18, the electrically conductive film (13) having a thickness in a nanoscopic range.

**21.** A data carrier (90B) comprising a substrate (91B) made of insulating or semi-insulating material, and an array of the structures (10) of any of claims 1 to 18 arranged in a spaced-apart relationship on top of said substrate, the structures thereby forming first data regions (921B) having magnetic moment spaced by second data regions (922B) with no magnetic moment.

**22.** A data carrier according to claim 21, comprising an insulating or semi-insulating substrate (91B) whose surface is patterned to define the first data regions (921B) spaced from each other by second regions (922B) of the substrate surface, wherein each of the first data regions (921 B) carries the electrically conductive film (92) and the organic molecules (93) adsorbed on and extending from said film (92).

**23.** A device comprising the nanoscopic structure (10) as defined in any one of claims 1 to 18, the device thereby enabling selective magnetization of regions of said structure to form a pattern including spaced-apart regions (921B) of the structure having magnetic moment spaced by the regions (922B) of the structure with no magnetic moment.

**24.** A data carrier comprising a nanoscopic structure (10) as defined in any one of claim 1 to 18 being selectively magnetized to form a pattern including first magnetized data regions (921B) having magnetic moment spaced by second non-magnetized regions (922B) having no magnetic moment, the data being readable by measuring transmission of spin polarized electrons through the structure.

**25.** A spin filter device (130) for producing a spin-polarized current, the device comprising:

the spintronic structure (10) of any one of Claims 1 to 18;
a source of magnetic field (134) arranged near said electrically conductive film (13) and operable for aligning spins of electrons in the film (13); and
a pair of terminals (132-133) distant from each other and coupled to said film (13), the terminals being arranged for allowing an electric current passage therebetween.

**Patentansprüche**

**1.** Eine nanoskopische Struktur (10), gebildet durch organische Moleküle, die adsorbiert werden auf und sich erstrecken von einer Oberfläche (12) eines elektrisch leitfähigen Films (13), der aus einer oder mehreren Metall enthaltenden Schichten gebildet wird, wobei die organischen Moleküle eine Bindungsgruppe enthalten, welche eine chemische Bindung mit der Oberfläche (12) bildet und eine sich selbst organisierende Monoschicht auf der Oberfläche (12) des elektrisch leitfähigen Films (13) bildet, wodurch die Struktur paramagnetische Eigenschaften und Spin-Selektivität für die Elektronentransmission **dadurch** zur Verwendung in der Spintronik hat.

**2.** Die Struktur gemäß Anspruch 1, worin die organischen Moleküle im Wesentlichen dieselbe Länge haben.

**3.** Die Struktur gemäß Anspruch 1, worin die organischen Moleküle thiolierte Moleküle sind.

**4.** Die Struktur gemäß Anspruch 3, worin die thiolierten Moleküle Alkylthiole sind.

**5.** Die Struktur gemäß Anspruch 4, worin die Anzahl der Alkylgruppen in den Alkylthiolen im Bereich von 2 bis 30 liegen kann.

**6.** Die Struktur gemäß Anspruch 3, worin die thiolierten Moleküle Polyalanin sind, das durch eine Cystingruppe an die Oberfläche gebunden wird.

**7.** Die Struktur gemäß Anspruch 6, worin die Anzahl der Peptidgruppen in den Polyalanin-Molekülen im Bereich von 1 bis 50 liegen kann.

8. Die Struktur gemäß Anspruch 1, worin der elektrisch leitfähige Film (13) eine einzige Metallschicht aus einem reinen Material ist.

9. Die Struktur gemäß Anspruch 1, worin der elektrisch leitfähige Film (13) eine Kombination aus mehreren Metall-Teilschichten ist und jede Teilschicht aus einem reinen Material hergestellt ist.

10. Die Struktur gemäß Anspruch 1, worin der elektrisch leitfähige Film (13) aus einer Metalllegierung hergestellt ist.

11. Die Struktur gemäß Anspruch 1, worin der elektrisch leitfähige Film (13) aus einem Material hergestellt ist, das gewählt ist aus Gold, Aluminium, Kupfer und Chrom.

12. Die Struktur gemäß Anspruch 1, worin die Moleküle durch mindestens eine der folgenden Gruppen an die Oberfläche (12) des elektrisch leitfähigen Films (13) gebunden sind:

    Carboxyl-, Phosphate und Thiolgruppen.

13. Die Struktur gemäß Anspruch 1, die ein Substrat (14) umfasst, welches den elektrisch leitfähigen Film trägt.

14. Die Struktur gemäß Anspruch 13, worin das Substrat (14) ein Halbleiter ist.

15. Die Struktur gemäß Anspruch 13, worin das Substrat (14) aus isolierendem oder halbisolierendem Material hergestellt ist.

16. Die Struktur gemäß Anspruch 13, worin das Substrat (14) aus Silizium oder GaAs hergestellt ist.

17. Die Struktur gemäß Anspruch 1, worin die Dicke des elektrisch leitfähigen Films (13) im Wesentlichen 50 nm nicht uberschreitet.

18. DIe Struktur gemäß Anspruch 17, worin die Dicke des elektrisch leitfähigen Films (13) ungefähr 1-10 nm beträgt.

19. Eine paramagnetische Vorrichtung, welche die Struktur (10) eines beliebigen der Ansprüche 1 bis 18 umfasst, wobei der elektrisch leitfähige Film (13) eine Dicke in einem nanoskopischen Bereich hat.

20. Ein spinselektives Material für Spintronik, welches die Struktur (10) eines beliebigen der Ansprüche 1 bis 18 umfasst, wobei der elektrisch leitfähige Film (13) eine Dicke in einem nanoskopischen Bereich hat.

21. Ein Datenträger (90B), der ein Substrat (91B) umfasst, das aus isolierendem oder halbisolierendem Material hergestellt ist, und ein Array der Strukturen (10) gemäß einem beliebigen der Ansprüche 1 bis 18, angeordnet in einer beabstandeten Beziehung oben auf dem Substrat, wodurch die Strukturen erste Datenbereiche (921B) mit Magnetmoment bilden, beabstandet durch zweite Datenbereiche (922B) ohne Magnetmoment.

22. Ein Datenträger gemäß Anspruch 21, der ein isolierendes oder halbisolierendes Substrat (91B) umfasst, dessen Oberfläche gemustert ist, um die ersten Datenbereiche (921B) zu bestimmen, die durch zweite Bereiche (922B) der Substratoberfläche voneinander beabstandet sind, wobei jeder der ersten Datenbereiche (921B) den elektrisch leitfähigen Film (92) und die organischen Moleküle (93) trägt, die auf dem Film (92) adsorbiert werden und sich davon erstrecken.

23. Eine Vorrichtung, welche die nanoskopische Struktur (10) wie in einem beliebigen der Ansprüche 1 bis 18 definiert umfasst, wodurch die Vorrichtung selektive Magnetisierung von Bereichen der Struktur ermöglicht, um ein Muster zu bilden, das beabstandete Bereiche (921B) der Struktur mit Magnetmoment einschließt, die durch die Bereiche (922B) der Struktur ohne Magnetmoment beabstandet sind.

24. Ein Datenträger, der eine nanoskopische Struktur (10) wie in einem beliebigen der Ansprüche 1 bis 18 definiert umfasst, die zur Bildung eines Musters selektiv magnetisiert wird, das erste magnetisierte Datenbereiche (921B) mit Magnetmoment einschließt, die durch zweite nicht magnetisierte Bereiche (922B) ohne Magnetmoment beabstandet sind, wobei die Daten durch die Messung der Übertragung von spinpolarisierten Elektronen durch die Struktur lesbar sind.

25. Eine Spin-Filter-Vorrichtung (130) zur Erzeugung eines spinpolarisierten Stroms, wobei die Vorrichtung Folgendes umfasst:

die spintronische Struktur (10) gemäß einem beliebigen der Ansprüche 1 bis 18;
eine Quelle für ein Magnetfeld (134), angeordnet nahe dem elektrisch leitfähigen Film (13) und bedienbar zur Ausrichtung von Elektronenspins im Film (13); und
ein Paar von Klemmen (132-133), voneinander entfernt und mit dem Film (13) gekoppelt, wobei die Klemmen angeordnet sind, um einen Stromdurchgang dazwischen zu ermöglichen.

**Revendications**

1. Structure nanoscopique (10) formée de molécules organiques adsorbées sur ou s'étendant à partir d'une surface d'un film électriquement conducteur (13) formé d'une ou plusieurs couches contenant du métal, lesdites molécules organiques contenant un groupe de liaison formant une liaison chimique sur ladite surface (12) et formant une monocouche auto-assemblée sur ladite surface (12) du film électriquement conducteur (13), la structure ayant ainsi des propriétés paramagnétiques et une sélectivité en spin pour transmission électronique à travers elle pour utilisation en spintronique.

2. Structure selon la revendication 1, dans laquelle lesdites molécules organiques ont sensiblement la même longueur.

3. Structure selon la revendication 1, dans laquelle lesdites molécules organiques sont des molécules thiolées.

4. Structure selon la revendication 3, dans laquelle lesdites molécules thiolées sont des alkylthiols.

5. Structure selon la revendication 4, dans laquelle le nombre des groupes alkyle dans les alkylthiols peut être dans la plage de 2 à 30.

6. Structure selon la revendication 3, dans laquelle lesdites molécules thiolées sont liées par polyalanine à ladite surface par le biais d'un groupe cystine.

7. Structure selon la revendication 6, dans laquelle le nombre des groupes peptide dans les molécules de polyalanine peut être dans la plage de 1 à 50.

8. Structure selon la revendication 1, dans laquelle ledit film électriquement conducteur (13) est une couche monométal d'un matériau pur.

9. Structure selon la revendication 1, dans laquelle ledit film électriquement conducteur (13) est une combinaison de plusieurs sous-couches de métal, chaque sous-couche étant constituée d'un matériau pur.

10. Structure selon la revendication 1, dans laquelle ledit film électriquement conducteur (13) est constitué d'un alliage de métal.

11. Structure selon la revendication 1, dans laquelle ledit film électriquement conducteur (13) est constitué d'un matériau choisi parmi l'or, l'aluminium, le cuivre et le chrome.

12. Structure selon la revendication 1, dans laquelle les molécules sont liées à la surface (12) du film électriquement conducteur (13) par le biais d'au moins un des groupes suivants : groupes carboxylique, phosphates et thiols.

13. Structure selon la revendication 1, comprenant un substrat (14) supportant ledit film électriquement conducteur.

14. Structure selon la revendication 13, dans lequel le substrat (14) est un semi-conducteur.

15. Structure selon la revendication 13, dans laquelle ledit substrat (14) est constitué d'un matériau isolant ou semi-isolant.

**16.** Structure selon la revendication 13, dans laquelle ledit substrat (14) est constitué de silicium ou de GaAs.

**17.** Structure selon la revendication 1, dans laquelle l'épaisseur du film électriquement conducteur (13) ne dépasse pas sensiblement 50 nm.

**18.** Structure selon la revendication 17, dans laquelle l'épaisseur du film électriquement conducteur (13) est d'environ 1-10 nm.

**19.** Dispositif paramagnétique comprenant la structure (10) selon l'une quelconque des revendications 1 à 18, le film électriquement conducteur (13) ayant une épaisseur dans une plage nanoscopique.

**20.** Matériau sélectif en spin pour spintronique comprenant la structure (10) selon l'une quelconque des revendications 1 à 18, le film électriquement conducteur (13) ayant une épaisseur dans une plage nanoscopique.

**21.** Support de données (90B) comprenant un substrat (91B) constitué d'un matériau isolant ou semi-isolant, et d'un ensemble des structures (10) selon l'une quelconque des revendications 1 à 18 agencées selon une relation espacée au-dessus dudit substrat, les structures formant ainsi des premières régions de données (921B) ayant un moment magnétique espacées par des secondes régions de données (922B) n'ayant pas de moment magnétique.

**22.** Support de données selon la revendication 21, comprenant un substrat isolant ou semi-isolant (91B) dont la surface est modelée pour définir les premières régions de données (921B) espacées les unes des autres par des secondes régions (922B) de la surface du substrat, dans lequel chacune des premières régions de données (921B) supporte le film électriquement conducteur (92) et les molécules organiques (93) adsorbées sur ledit film (92) et s'étendant à partir de celui-ci.

**23.** Dispositif comprenant la structure nanoscopique (10) selon l'une quelconque des revendications 1 à 16, le dispositif permettant ainsi la magnétisation sélective de régions de ladite structure pour former un motif comprenant les régions espacées (921B) de la structure ayant un moment magnétique espacées par les régions (922B) de la structure n'ayant pas de moment magnétique.

**24.** Support de données comprenant une structure nanoscopique (10) selon l'une quelconque des revendications 1 à 18 étant magnétisée sélectivement pour former un modèle incluant des premières régions de données magnétisées (921B) ayant un moment magnétique espacées par des secondes régions non magnétisées (922B) n'ayant pas de moment magnétique, les données étant lisibles en mesurant la transmission des électrons polarisés en spin à travers la structure.

**25.** Dispositif de filtre à spin (130) pour produire un courant polarisé en spin, le dispositif comprenant :

la structure spintronique (10) selon l'une quelconque des revendications 1 à 18 ;
une source de champ magnétique (134) agencée près dudit film électriquement conducteur (13) et utilisable pour aligner les spins d'électrons dans le film (13) ; et
une paire de bornes (132-133) distantes l'une de l'autre et couplées audit film (13), les bornes étant agencées pour permettre le passage d'un courant électrique entre elles.

FIG. 1

FIG. 2A          FIG. 2B

FIG. 2C

FIG. 2D

FIG. 3

FIG. 4A

FIG. 4B

FIG. 5

FIG. 6

FIG. 7

FIG. 8

FIG. 9

FIG. 10A

FIG. 10B

Poly D N terminal

297K

○ ○ ○ ○ linear pol.
——— (-)
— — — (+)

Signal (a.u.)

Electron Energy (eV)  FIG. 10C

297K

Poly D C terminal

Signal (a.u.)

Electron Energy (eV)  FIG. 10D

Signal (a.u.)

FIG. 11

Electron Energy (eV)

FIG.12

EP 1 606 215 B1

Transferred pairs
of electrons

Molecular
electrons

FIG. 13

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6249453 B, You
- US 6355953 B, Kirczenow
- US 20020117727 A, Engel
- US 20020064005 A, Arasawa
- US 20030001154 A, Epstein
- US 20020025374 A, Lee
- WO 0229911 A, Slaughter
- WO 0235559 A, Engel
- US 20020158342 A, Tuominen
- JP 6045142 B
- EP 561279 A
- WO 02091384 A

### Non-patent literature cited in the description

- **S. A. WOLF et al.** *Science,* 2001, vol. 294, 1488
- **S. DAS SARMA.** *American Scientist,* 2001, vol. 89, 516
- **H. OHNO et al.** *JSAP International,* January 2002, 4
- **G. A. PRINZ.** *Science,* 1998, vol. 282, 1660
- **Z. VAGER et al.** *Chem Phys.,* 2002, vol. 281, 305
- **K. RAY et al.** *Science,* 1999, vol. 814, 283
- **L. KRONIK et al.** *Surface Science Reports,* 1999, vol. 37, 1
- **F. MEIER et al.** *Phys. Rev. Lett.,* 1981, vol. 47, 374
- *Phys. Rev. Lett.,* 1984, vol. 52, 1152
- **G. BORSTEL et al.** *Phys. Rev,* 1982, vol. B 26, 1148
- **R. NAAMAN et al.** *J. Phys. Chem. B,* 1998, vol. 102, 3658
- **W.G.J. HOL et al.** *Nature,* 1978, vol. 273, 443
- **C.F.J. FLIPSE ; C.B. ROUWELAAR ; F.M.F. DE GROOT.** *Eur. Phys. J.,* 1999, vol. D 9, 479
- **R.A. SEROTA.** *Solid State Com.,* 2001, vol. 117, 99
- **I. CABRIA ; B. NONAS ; R. ZELLER ; P.H. DEDERICHS.** *Phys. Rev. B,* 2002, vol. 65, 054414
- **N. HARRISON.** *Phys. Rev. B,* 2002, vol. 66
- **R. BURIONI ; D. CASSI ; A. VEZZANI.** *J. Phys. A: Math. Gen.,* 2002, vol. 35, 1245
- **R. P. FEYNMAN.** Statistical Mechanics. PERSEUS BOOKS, 1998